# EUROPÄISCHE PATENTANMELDUNG

(11) **EP 2 020 831 A1**
(43) Veröffentlichungstag der Anmeldung: **04.02.2009**
(21) Anmeldenummer: 07015019.8
(22) Anmeldetag: 31.07.2007
(51) Int. Cl.: H05K 1/00, H05K 1/18, D03D 15/00

(54) **Verfahren zum Herstellen eines Elektroniktextils und Textilsubstrat**

(71) Anmelder: Sefar AG, 9410 Heiden (CH)
(72) Erfinder: Locher , Ivo, 6300 Zug (CH); Maurer, Christoph, 8044 Zürich (CH); Strotz, Marcel, 8854 Siebnen (CH)
(74) Vertreter: Wunderlich, Rainer

(57) **Zusammenfassung**

Die Erfindung betrifft ein Verfahren zum Herstellen eines Elektroniktextiles, bei dem ein mit Fäden gewebtes Textilsubstrat vorgesehen wird, bei welchem zumindest ein Teil der Fäden elektrisch leitende Fäden sind, und eine Leiterbahnanordnung durch Kontaktieren elektrisch leitender Fäden erzeugt wird. Eine besonders zuverlässige Kontaktierung wird zum einen dadurch erreicht, dass ein Teil der Fäden mit einer Kontrastfarbe versehen ist, welche sich von der Farbe der anderen Fäden unterscheidet, wobei ein Markierungsmuster gebildet wird. Zum anderen ist vorgesehen, dass das Textilsubstrat vor dem Kontaktieren auf einen Stabilisierungsträger aufgeklebt oder aufgespannt wird und dass nach dem Erzeugen der Leiterbahnanordnung das Textilsubstrat von dem Stabilisierungsträger wieder gelöst wird.

## Beschreibung

Die Erfindung betrifft ein Verfahren zum Herstellen eines Elektroniktextils, bei dem ein mit Fäden gewebtes Textilsubstrat vorgesehen wird, bei welchem zumindest ein Teil der Fäden elektrisch leitende Fäden sind, und eine Leiterbahnanordnung durch Kontaktieren elektrisch leitender Fäden erzeugt wird. Weiterhin betrifft die Erfindung ein Textilsubstrat zum Bilden eines Elektroniktextiles, welches mit Fäden gewebt ist, von denen zumindest ein Teil der Fäden elek-trisch leitende Fäden sind.

Derartige Verfahren zum Herstellen eines Elektroniktextiles sowie ein zugehöriges Textilsubstrat sind beispielsweise aus der EP 1 722 614 A1 und der EP 1 727 408 A1 bekannt.

Es besteht ein immer stärker zunehmendes Bedürfnis, Textilien, insbesondere Bekleidungsstücke, mit elektrischen und elektronischen Funktionen auszustatten. Einhergehend mit der Miniaturisierung elektrischer Geräte, wie Mobiltelefone, Computer, PDA's, MP3-Player etc. werden diese Geräte in so genannten Elektroniktextilien integriert. Neben diesen Bereichen können Elektroniktextilien auch in verschiedenen anderen Bereichen zum Einsatz gelangen, bei welchen die Kombination elektrischer und elektronischer Funktionen mit der Flexibilität und Strapazierfähigkeit eines Textiles vorteilhaft ist.

Hierzu werden gewebte Textilsubstrate eingesetzt, welche auch als flexible oder textile Leiterplatten bezeichnet werden. Diese Textilsubstrate bestehen in der Regel aus einer Kombination leitender und nicht leitender Fäden. Die elektrisch leitenden Fäden werden dabei gleichmäßig verteilt mit den nicht leitenden Fäden in hoher Stückzahl in dem Gewebe angeordnet. Abhängig von den aufzubringenden Elektronikkomponenten erfolgt eine lokale Abisolierung und elektrische Verbindung mit den elektrisch leitenden Fäden.

Bei einer hohen Anzahl und einer feinen Verteilung der elektrisch leitenden Fäden besteht jedoch die Gefahr von Fehlkontaktierungen. Dies kann bei der Herstellung zu erheblichem Ausschuss führen.

Um eine zuverlässige Kontaktierung zu ermöglichen, wird in der EP 1 727 408 A1 gelehrt, Adapterelemente mit unterschiedlichen Anschlussbereichen vorzusehen. Ein Anschlussbereich auf einer Seite ist dabei auf die entsprechenden Kontaktpunkte einer elektronischen Komponente ausgerichtet, während die andere Seite möglichst weit zueinander beabstandete Anschlusspunkte für die Kontaktstellen des Textilsubstrates aufweist.

Der Erfindung liegt die **Aufgabe** zugrunde, ein Verfahren zum Herstellen eines Elektroniktextiles und eines Textilsubstrates anzugeben, welche ein effizientes und besonders zuverlässiges Bilden einer Leiterbahnanordnung ermöglichen.

Die Aufgabe wird zum einen durch ein Verfahren mit den Merkmalen des Anspruchs 1 oder ein Verfahren mit den Merkmalen des Anspruchs 7 und zum anderen durch ein Textilsubstrat mit den Merkmalen des Anspruchs 8 gelöst. Bevorzugte Ausführungsformen sind in den jeweils abhängigen Ansprüchen angegeben.

Das eine erfindungsgemäße Verfahren ist dadurch gekennzeichnet, dass ein Teil der Fäden mit einer Kontrastfarbe versehen ist, welche sich von der Farbe der anderen Fäden unterscheidet, wobei ein Markierungsmuster zum exakten Erzeugen der Leiterbahnanordnung gebildet wird.

Gemäß der Erfindung wird bereits bei der Herstellung des Textilsubstrates neben der eigentlichen Gewebestruktur ein Markierungsmuster aufgebracht. Das Markierungsmuster ermöglicht ein exaktes Positionieren und Erzeugen von Kontaktstellen und beugt so Fehlkontaktierungen vor.

Die Leiterbahnanordnung kann eine Anordnung von Spulen oder Schleifen für Heizungen oder Antennen sein, welche durch einfaches elektrisches Kontaktieren sich kreuzender leitender Fäden gebildet werden. Zum Bilden der Leiterbahnanordnung können alternativ oder ergänzend elektronische Komponenten auf das Textilsubstrat aufgebracht und angeschlossen werden. Im Sinne der Erfindung sind elektronische Komponenten nicht nur Komponenten mit integrierten Schaltkreisen, sondern umfassen auch andere elektrisch betriebene oder gesteuerte Komponenten, etwa Dioden, Schalter, Sensoren, Aktoren, Leuchtbirnen etc.. Abhängig von der Farbe der normalen Fäden des Textilgewebes wird die Kontrastfarbe zur Erzeugung des Markierungsmusters mit einem möglichst großen Kontrastunterschied gewählt. Besonders bevorzugt ist hierbei Hell-Dunkel-, insbesondere ein Schwarz-Weiß-Kontrast. Dieser starke Kontrast ist insbesondere für eine automatisierte Positionierung und Aufbringung der elektronischen Komponenten vorteilhaft.

Grundsätzlich können die gefärbten Fäden mit einem unregelmäßigen Abstand zueinander angeordnet sein und so ein nicht regelmäßiges Markierungsmuster bilden. Unter Fertigungsgesichtspunkten des Textilsubstrates ist es jedoch vorteilhaft, dass das Markierungsmuster in einer regelmäßigen Linien- oder Gitterstruktur gebildet wird. Bei dieser regelmäßigen Struktur besteht ein gleich bleibender Linien- oder Gitterabstand der markierten Fäden zueinander. Beispielsweise kann jeder zehnte oder jeder fünfzigste Faden markiert sein. Vorzugsweise sind die Fäden bereits vor dem Weben des Textilsubstrates gefärbt, so dass sich entsprechend der Webstruktur in Kett- und/oder Schussrichtung eine gewünschte Linien- oder Gitterstruktur von selbst ergibt.

Insbesondere wenn die leitenden und nicht leitenden Fäden mit nahezu gleichem Fadendurchmesser und ähnlichen mechanischen Eigenschaften ausgewählt sind, kann die Kontrastfarbe sowohl auf einem Teil beider Fäden oder nur auf einem Teil der nicht leitenden Fäden vorgesehen sein. Besonders effizient ist es nach Erfindung, dass als Fäden mit der Kontrastfarbe ausschließlich elektrisch leitende Fäden vorgesehen werden. Dabei sind nur ein Teil der elektrisch leitenden Fäden gefärbt. Die Kontrastfarbe kann gleichzeitig eine elektrische Isolierschicht oder zumindest einen Teil hiervor an den elektrisch leitenden Fäden bilden. Die elektrisch leitenden Fäden können einen Durchmesser zwischen 0,5 µm bis 500 µm besitzen. Die elektrisch leitenden Fäden können dabei einen Metallfaden, einen elektrisch leitenden Kunststofffaden oder einen nicht leitenden Kunststofffaden mit einer elektrisch leitenden Metallumhüllung aufweisen, an welchen dann jeweils die elektrisch nicht leitende Isolierschicht aufgebracht ist.

Ein wirtschaftliches Verfahren zur Herstellung ergibt sich nach der Erfindung weiterhin dadurch, dass die elektrisch leitenden Fäden mit einer Isolierschicht überzogen sind, welche zum Bilden elektrisch leitender Kontaktstellen mittels einer Abisoliereinrichtung lokal entfernt wird, und dass mittels einer Zuführrichtung ein Leit- und Verbindungsmaterial an den Kontaktstellen aufgebracht wird. Hierdurch wird eine industrielle Fertigung, also eine zuverlässige und kostengünstige Fertigung in großen Stückzahlen, möglich. Die Abisoliereinrichtung kann dabei insbesondere eine Lasereinheit umfassen, mit welcher die Isolierschicht verdampft oder abgebrannt werden kann.

Eine besonders bevorzugte Verfahrensvariante besteht nach der Erfindung darin, dass mindestens eine elektronische Komponente mittels einer Bestückungseinrichtung an Kontaktstellen aufgebracht wird und dass nach dem Aufbringen der mindestens einen elektronischen Komponente mittels einer Verbindungseinrichtung die mindestens eine elektronische Komponente elektrisch leitend und mechanisch fest an dem Textilsubstrat angeschlossen wird. Das Leit- und Verbindungsmaterial kann ein Lötmaterial aus einem Metall oder einem leitenden Kunststoff oder ein leitender Klebstoff sein. Die Zuführeinrichtung kann beispielsweise eine Druckstation sein, welche das Leit- und Verbindungsmaterial in Pulver- oder Pastenform positionsgenau an den abisolierten Kontaktstellen aufbringt. Besonders bevorzugt ist das Aufbringen durch Schablonen- oder Siebdruck. Entsprechend dem verwendeten Leit- und Verbindungsmaterial kann die Verbindungseinrichtung eine Heizeinrichtung zum Aufschmelzen eines Lotes oder eine Härteinrichtung zum Aushärten von Klebstoffmaterial sein. Die Bestückungseinrichtung kann einen Greifer aufweisen, welcher mittels entsprechender Verfahrachsen die elektronischen Komponenten von einer Zuführstation aufnimmt und gemäß einer Computersteuerung positionsgenau an den gewünschten Kontaktstellen aufbringt.

Eine besonders wirtschaftliche Fertigung wird erfindungsgemäß dadurch erreicht, dass die Abisoliereinrichtung, die Bestückungseinrichtung, die Zuführeinrichtung und/oder die Verbindungseinrichtung ein optisches Steuerelement aufweisen, mit welchem eine Ausrichtung und Positionierung an dem Markierungsmuster erfolgt. Zumindest eine der genannten Einrichtungen kann ein opto-elektronisches Steuerelement umfassen. Das Steuerelement weist in bekannter Weise einen optischen Sensor auf, welcher Kontraste erkennen kann. Hierdurch werden eine automatische Erkennung des Markierungsmusters und damit eine besonders exakte Positionierung und Kontaktierung ermöglicht.

Die eingangs genannte Aufgabe wird weiterhin durch ein Verfahren mit den Merkmalen des Anspruchs 7 gelöst. Dieses erfindungsgemäße Verfahren ist dadurch gekennzeichnet, dass das Textilsubstrat vor dem Kontaktieren auf einen Stabilisierungsträger aufgeklebt oder aufgespannt wird und dass nach dem Erzeugen der Leiterbahnanordnung das Textilsubstrat von dem Stabilisierungsträger wieder gelöst wird. Dieses Verfahren kann in beliebiger Kombination mit einem der vorher genannten Verfahrensschritte oder auch unabhängig davon eingesetzt werden. Das Aufkleben des hochflexiblen Textilsubstrates auf einen Stabilisierungsträger, insbesondere eine starre Platte, ein steiferes Band oder eine Folie, fixiert und stabilisiert das sehr flexible Textilsubstrat. Der Stabilisierungsträger kann auch ein Rahmen sein, in welchem das Textilsubstrat aufgespannt wird. Somit kann auch bei einer sehr feinen Verteilung von elektrisch leitenden Fäden die Gefahr einer unerwünschten Fehlkontaktierung in weitem Maße vermieden werden. Nachdem etwa die elektronisch leitenden Komponenten mechanisch fest und elektrisch leitend aufgebracht worden sind, kann der Stabilisierungsträger wieder von dem Textilsubstrat gelöst werden. Dies kann beispielsweise unter Verwendung erhöhter Temperatur und/oder einem Lösungsmittel erfolgen.

Gemäß der Erfindung ist das Textilsubstrat dadurch gekennzeichnet, dass ein Teil der Fäden mit einer Kontrastfarbe versehen ist, welche sich von der Farbe der anderen Fäden unterscheidet, wobei ein Markierungsmuster gebildet ist. Hierdurch werden bei der Verarbeitung zu einem Elektroniktextil die zuvor beschriebenen Vorteile sichergestellt.

Für eine effiziente Weiterverarbeitung ist es dabei erfindungsgemäß, dass das Markierungsmuster in einer regelmäßigen Linien- und/oder Gitterstruktur gebildet ist.

Zur Erreichung der vorstehend genannten Vorteile ist erfindungsgemäß ein Elektroniktextil mit einem Textilsubstrat mit elektrisch leitenden Fäden und einer Leiterbahnordnung an dem Textilsubstrat mit elektrisch leitenden Fäden ausgebildet ist. Dieses Elektroniktextil ist dadurch gekennzeichnet, dass ein erfindungsgemäß beanspruchtes Textilsubstrat vorgesehen ist.

Die Erfindung wird weiter anhand von bevorzugten Ausführungsbeispielen weiter erläutert, welche schematisch in den Zeichnungen dargestellt sind. In den Zeichnungen zeigen:
- Fig. 1: ein erfindungsgemäßes Textilsubstrat mit teilweise gefärbten Fäden;
- Fig. 2: einen Ausschnitt eines Elektroniktextiles mit zwei elektronischen Komponenten;
- Fig. 3: das Aufbringen einer elektronischen Komponente auf ein Textilsubstrat mit Stabilisierungsträger; und
- Fig. 4: einen Ausschnitt eines erfindungsgemäßen Elektroniktextiles mit zwei angebrachten elektronischen Komponenten.

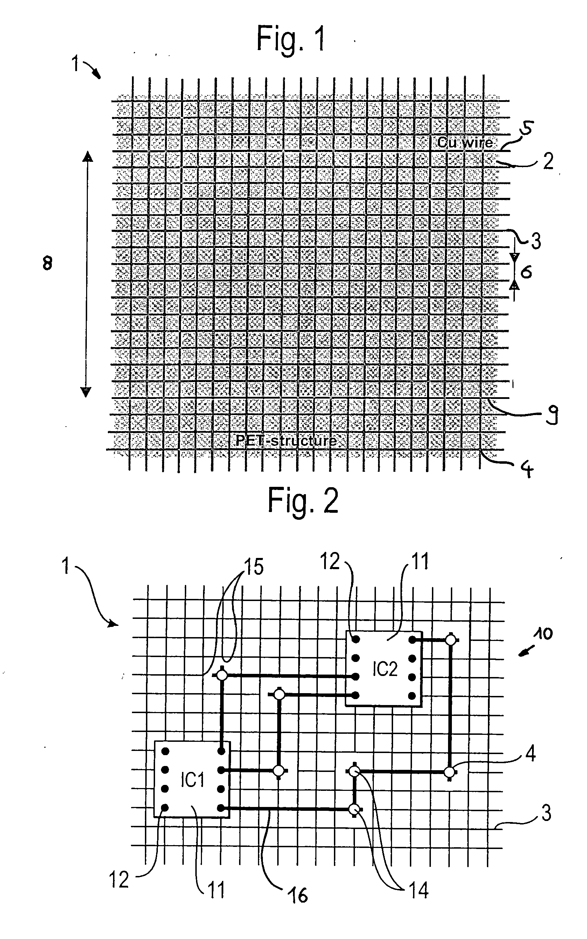

Fig. 1 zeigt schematisch ein erfindungsgemäßes Textilsubstrat 1. Das Textilsubstrat 1 besteht aus gitterförmig angeordneten elektrisch leitenden Fäden 3, welche einen Abstand 6 zueinander haben und einer Vielzahl nur schematisch angedeuteter elektrisch nicht leitender Fäden, deren Anzahl größer ist als die der elektrisch leitenden Fäden 3. Die Anzahl der nicht leitenden Fäden 2 kann aber auch größer als gleich der Anzahl der leitenden Fäden 3 sein. Die Fäden 2, 3 sind miteinander zu einem Gewebe verwebt und bilden ein regelmäßiges Raster.

Von den elektrisch leitenden Fäden 3 ist jeder fünfzehnte Faden mit einer Kontrastfarbe 5 versehen. Der Abstand der Fäden mit Kontrastfarbe 5 kann jedoch beliebig sein, etwa jeder 50-zigste kann gefärbt sein. Dies gilt sowohl in Schuss- als auch in Kettrichtung. Die Kontrastfarbe 5 ist deutlich dunkler als die Farbe der verbliebenen elektrisch leitenden Fäden 3 und der nicht leitenden Fäden 2. Auf diese Weise wird ein gitterförmiges, rechtwinkeliges Markierungsmuster 9 mit einem Markierungsabstand 8 integriert im Gewebe erreicht.

Die nicht leitenden Fäden 2 bestehen aus PET und bilden eine PET-Struktur, während die elektrisch leitenden Fäden 3 aus Kupfer bestehen und von einer Isolierschicht umhüllt sind. Bedingt durch die isolierende Schicht der leitenden Fäden 3 findet an Kreuzungsstellen 4 zwei elektrisch leitender Fäden 3 kein elektrischer Kontakt zwischen diesen beiden Fäden 3 statt.

In Fig. 2 ist Leiterbahnanordnung 16 mit zwei elektronischen Komponenten 11 auf einem erfindungsgemäßen Textilsubstrat 1 dargestellt. In dieser Figur sind nur die leitenden Fäden 3 dargestellt, während die nicht leitenden Fäden 2 aus Übersichtlichkeitsgründen weggelassen wurden. Um eine gewünschte Leiterbahnanordnung 16 zu erzeugen, kann an bestimmten Kreuzungssstellen 4 von zwei elektrisch leitenden Fäden 3 die Isolierung durch eine nicht dargestellte Lasereinrichtung entfernt werden. Anschließend werden die abisolierten Stellen der beiden elektrisch leitenden Fäden 3 durch einen leitenden Kleber oder durch Lötzinn elektrisch leitend verbunden. So entsteht eine leitende Verbindungsstelle 14 oder Kontaktierung zwischen zwei leitenden Fäden 3. Um eine erzeugte Leiterbahn räumlich zu begrenzen, können elektrisch leitende Fäden 3 an entsprechenden Stellen mit einem Schnitt 15 durchtrennt werden. Dieser Schnitt kann ebenfalls durch die Lasereinrichtung erfolgen.

Zum Bilden eines erfindungsgemäßen Elektroniktextiles 10 werden im dargestellten Beispiel auf das Textilsubstrat 1 mehrere elektronische Komponenten 11 aufgebracht. Diese weisen hierzu Anschlussanordnungen 12 auf. Diese Anschlussanordnungen 12 müssen mit den jeweiligen dafür vorgesehenen elektrisch leitenden Fäden 3 verbunden werden. Hierzu wird ebenfalls an einer definierten Stelle die Außenisolierung eines oder mehrerer elektrisch leitender Fäden 3 entfernt. Bevorzugt eignen sich hierfür Kreuzungspunkte. Diese Kontaktstellen werden mittels eines elektrisch leitenden Klebers mit einem Anschlusspunkt der Anschlussanordnung 12 elektrisch leitend verbunden. Dies erfolgt für jeden Anschlusspunkt eines elektronischen Bauelementes 11.

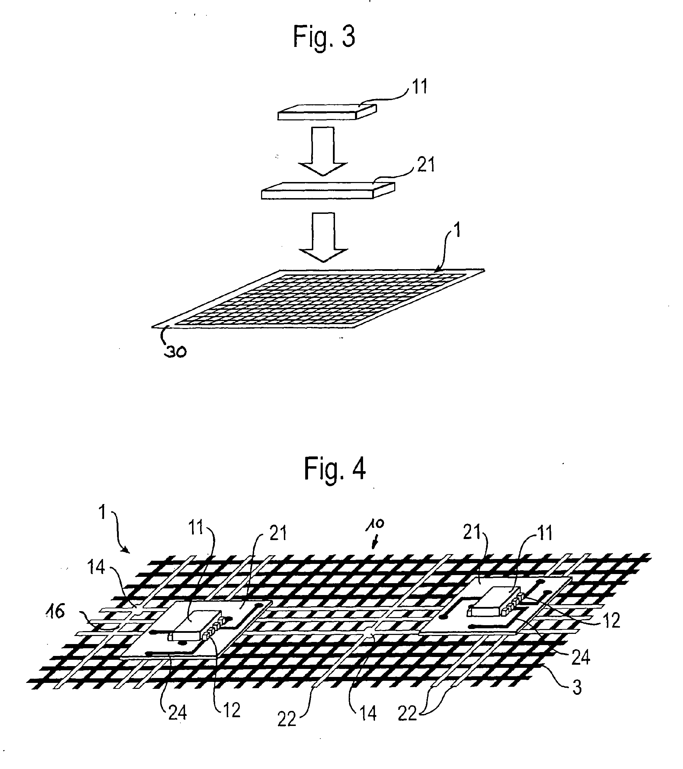

Zur zuverlässigen Positionierung von elektronischen Komponenten 11 auf dem sehr feinen und flexiblen Textilsubstrat 1, welches auch als eine gewebte Leiterplatte bezeichnet wird, wird dieses gemäß Fig. 3 zunächst auf einen festeren Stabilisierungsträger 30 aufgebracht und dort mittels eines Klebers fixiert. In dieser fixierten, stabilen Lage kann nunmehr das Aufbringen der elektronischen Komponente 11 erfolgen. Für eine Verbesserung des Anschlusses kann hierbei auch ein Adapterelement 21 vorgesehen werden. Dieses Adapterelement 21 vereinfacht es, bei einem sehr engen Abstand 6 eine genaue Positionierung auf den gewünschten Kontaktierungspunkten auszuführen, da das Adapterelement 21 vorzugsweise größer ausgelegt ist als die elektronische Komponente 11. Es entsteht durch das Adapterelement 21 auch eine bessere physikalische Verbindung mit dem Textilsubstrat 1. Ein weiterer Vorteil des Adapterelementes 21 besteht darin, dass das Adapterelement 21 genau auf das verwendete Texilsubstrat 1 mit deren Abstand 6 von leitenden Fäden 3 angepasst werden kann. Die Oberseite des Adapterelements 21, auf der die elektronische Komponente 11 angebracht wird, kann wiederum auf spezielle Komponente 11 angepasst sein. Gemäß der Erfindung kann entweder zunächst das Adapterelement 21 auf das Textilsubstrat 1 aufgebracht und anschließend die elektronische Komponente 21 angeschlossen werden, oder alternativ kann zunächst ein Verbinden der elektronischen Komponente 11 mit dem Adapterelement 21 erfolgen. Die so ergänzte und vorbereitete elektronische Komponente 11 kann dann auf das Textilsubstrat 1 aufgebracht und angeschlossen werden.

Wie in Fig. 4 gezeigt, werden nicht alle elektrisch leitenden Fäden 3 eines Textilsubstrates 1 zum Aufbau einer Leiterbahnanordnung 16 benötigt (hier sind wiederum nur die leitenden Fäden 3 dargestellt). In dieser Figur sind die verwendeten elektrisch leitenden Fäden 22 in heller Farbe dargestellt. Auf dem gezeigten Abschnitt des so gebildeten Elektroniktextiles 10 sind zwei elektronische Komponenten 11 mittels Adapterelementen 21 auf dem Textilsubstrat 1 angebracht. Um die Kontaktierungspunkte zwischen der elektronischen Komponente 11 und dem Textilsubstrat 1 zu entzerren, weist das Adapterelement 21 Leitungen 24 auf, die von den Anschlussanordnungen 12 zu den jeweiligen Verbindungspunkten des Textilsubstrates 1 führen.

Durch das erfindungsgemäße Elektroniktextil 10, das aus elektrisch leitenden und elektrisch nicht leitenden Fäden besteht und elektronische Komponenten 11 aufweist, wird eine Leiterbahnanordnung 16 ähnlich einer herkömmlichen Leiterplatte geschaffen, welche jedoch bei der Verwendung als oder in Kombination mit Textilien kaum die Textileigenschaften eines Trägermaterials beeinflusst oder verschlechtert.

## Patentansprüche

1. Verfahren zum Herstellen eines Elektroniktextils (10), bei dem
- ein mit Fäden (2, 3) gewebtes Textilsubstrat (1) vorgesehen wird, bei welchem zumindest ein Teil der Fäden (2, 3) elektrisch leitende Fäden (3) sind, und
- eine Leiterbahnanordnung (16) durch Kontaktieren elektrisch leitender Fäden (3) erzeugt wird,
**dadurch gekennzeichnet,**
- **dass** ein Teil der Fäden (2, 3) mit einer Kontrastfarbe (7) versehen ist, welche sich von der Farbe der anderen Fäden (2, 3) unterscheidet, wobei ein Markierungsmuster (9) zum exakten Erzeugen der Leiterbahnanordnung (16) gebildet wird.

2. Verfahren nach Anspruch 1,
**dadurch gekennzeichnet,**
**dass** das Markierungsmuster (9) in einer regelmäßigen Linien- oder Gitterstruktur gebildet wird.

3. Verfahren nach Anspruch 1 oder 2,
**dadurch gekennzeichnet,**
**dass** als Fäden mit der Kontrastfarbe (7) ausschließlich elektrisch leitende Fäden (3) vorgesehen werden.

4. Verfahren nach einem der Ansprüche 1 bis 3,
**dadurch gekennzeichnet,**
**dass** die elektrisch leitenden Fäden (3) mit einer Isolierschicht überzogen sind, welche zum Bilden elektrisch leitender Kontaktstellen (18) mittels einer Abisoliereinrichtung lokal entfernt wird, und
**dass** mittels einer Zuführeinrichtung ein Leit- und Verbindungsmaterial an den Kontaktstellen (18) aufgebracht wird.

5. Verfahren nach Anspruch 4,
**dadurch gekennzeichnet,**
**dass** mindestens eine elektronische Komponente (11) mittels einer Bestückungseinrichtung an den Kontaktstellen (18) aufgebracht wird, und
**dass** nach dem Aufbringen der mindestens einen elektronischen Komponente (11) mittels einer Verbindungseinrichtung die mindestens eine elektronische Komponente (11) elektrisch leitend und mechanisch fest an dem Textilsubstrat (1) angeschlossen wird.

6. Verfahren nach Anspruch 4 oder 5,
**dadurch gekennzeichnet,**
**dass** die Abisoliereinrichtung, die Bestückungseinrichtung, die Zuführeinrichtung und/oder die Verbindungseinrichtung ein optisches Steuerelement aufweisen, mit welchem eine Ausrichtung und Positionierung an dem Markierungsmuster (9) erfolgt.

7. Verfahren zum Herstellen eines Elektroniktextiles (10), bei dem
- ein mit Fäden (2, 3) gewebtes Textilsubstrat (1) vorgesehen wird, bei welchem zumindest ein Teil der Fäden (2, 3) elektrisch leitende Fäden (3) sind, und
- eine Leiterbahnanordnung (16) durch Kontaktieren von elektrisch leitenden Fäden (3) erzielt wird,
**dadurch gekennzeichnet,**
- **dass** das Textilsubstrat (1) vor dem Kontaktieren auf einen Stabilisierungsträger (30) aufgeklebt oder aufgespannt wird und
- **dass** nach dem Erzeugen der Leiterbahnanordnung (16) das Textilsubstrat (1) von dem Stabilisierungsträger (30) wieder gelöst wird.

8. Textilsubstrat zum Bilden eines Elektroniktextiles (10), insbesondere nach einem Verfahren nach einem der Ansprüche 1 bis 7, welches mit Fäden (2, 3) gewebt ist, von denen zumindest ein Teil der Fäden (2, 3) elektrisch leitende Fäden (3) sind,
**dadurch gekennzeichnet,**
**dass** ein Teil der Fäden (2, 3) mit einer Kontrastfarbe (7) versehen ist, welche sich von der Farbe der anderen Fäden (2, 3) unterscheidet, wobei ein Markierungsmuster (9) gebildet ist.

9. Textilsubstrat nach Anspruch 8,
**dadurch gekennzeichnet,**
**dass** das Markierungsmuster (9) in einer regelmäßigen Linien- und/oder Gitterstruktur gebildet ist.

10. Elektroniktextil mit
- einem Textilsubstrat (1) mit elektrisch leitenden Fäden (3) und
- einer Leiterbahnanordnung (16) an dem Textilsubstrat (1) mit elektrisch leitenden Fäden (3),
**dadurch gekennzeichnet,**
- **dass** ein Textilsubstrat (1) nach einem der Ansprüche 8 oder 9 vorgesehen ist.
